# EUROPEAN PATENT APPLICATION

(11) **EP 3 480 699 A1**
(43) Date of publication of application: **08.05.2019**
(21) Application number: 18188628.4
(22) Date of filing: 13.08.2018
(51) Int. Cl.: G06F 11/26, G06F 17/50

(54) **SIMULATION DEVICE AND PROGRAM FOR FAULT-INJECTION INTO A PLURALITY OF MODELS**

(30) Priority: 07.11.2017 JP 2017214395
(71) Applicant: Renesas Electronics Corporation, 135-0061 Tokyo (JP)
(72) Inventor: FUNABASHI, Yutaka, Koutou-ku,, Tokyo 135-0061, (JP); KOKUBO, Masahiro, Koutou-ku,, Tokyo 135-0061, (JP); ONO, Hirohiko, Koutou-ku,, Tokyo 135-0061, (JP)
(74) Representative: Betten & Resch

(57) **Abstract**

In order to control the occurrence of fault with respect to each of the models belonging to different simulation environments, a simulation device includes: a simulation unit that performs a simulation on a virtual device model of a first device; a simulation unit that performs a simulation on a virtual device model of a second device that performs a process using the first device; and a fault injection control unit that injects faults into the respective virtual device models, based on a scenario list including a scenario that shows the contents and occurrence conditions of the fault with respect to the first device as well as a scenario that shows the contents and occurrence conditions of the fault with respect to the second device.

## Description

### CROSS-REFERENCE TO RELATED APPLICATIONS

The disclosure of Japanese Patent Application No. 2017-214395 filed on November 7, 2017 including the specification, drawings and abstract is incorporated herein by reference in its entirety.

### BACKGROUND

The present invention relates to a simulation device and program, and more particularly, relates to a simulation device and program for injecting faults, for example, into virtual device models.

In areas such as automobile, aviation, and medicine with very high demand for safety, it is desired that product development takes place after simulating a state in which a real device failed, by using environments such as model based development and virtual development.

Patent Document 1 (Japanese Unexamined Patent Application Publication No. 2014-203314) discloses a simulation device including a fault injection means for inserting information of a fault state described in a fault model definition file into a model of a circuit that is coupled to a microcomputer, to perform a fault injection test corresponding to the inserted fault state.

### SUMMARY

In recent years, there have been increasing needs for integrating a plurality of simulation environments of different layers to validate the entire simulation environments. However, the simulation device described in Patent Document 1 can cause a fault to occur in a model of a circuit coupled to a microcomputer, but may not control the occurrence of a fault in another model belonging to a different simulation environment. In other words, in the simulation device described in Patent Document 1, it is difficult to inject faults into, for example, both microcomputer model and plant model in the execution of the test.

The above and other objects and novel features of the present invention will be apparent from the description of the present specification and the accompanying drawings.

According to an embodiment, a simulation device includes a fault injection control unit that injects faults into a first virtual device model of a first device as well as a second virtual device model of a second device, based on a scenario that shows the contents and occurrence conditions of the fault with respect to the first device, as well as a scenario that shows the contents and occurrence conditions of the fault with respect to the second device.

According to the above embodiment, it is possible to control the occurrence of a fault in each of the models belonging to different simulation environments in an integrated manner.

### BRIEF DESCRIPTION OF THE DRAWINGS

Fig. 1 is a block diagram showing an example of a configuration of a simulation device according to a summary of the embodiment;
Fig. 2 is a block diagram showing an example of a functional configuration of the simulation device according to the embodiment;
Fig. 3 is a block diagram showing an example of a hardware configuration of the simulation device according to the embodiment;
Fig. 4 is a schematic diagram showing fault injection in the simulation device according to a first embodiment;
Fig. 5 is a table showing an example of a test scenario list that an entire validation control part uses;
Fig. 6 is a table showing an example of a fault scenario list that a fault injection control supervisor uses in the first embodiment;
Fig. 7 is a table showing an example a fault scenario list that the fault injection control supervisor uses in a second embodiment; and
Fig. 8 is a schematic diagram showing fault injection in the simulation device according to a third embodiment.

### DETAILED DESCRIPTION

The following descriptions and the drawings are omitted and simplified as appropriate in order to clarify the explanation. Note that the same elements are denoted by the same reference numerals throughout the drawings and overlapping description will be omitted as appropriate.

### <Summary of the embodiment>

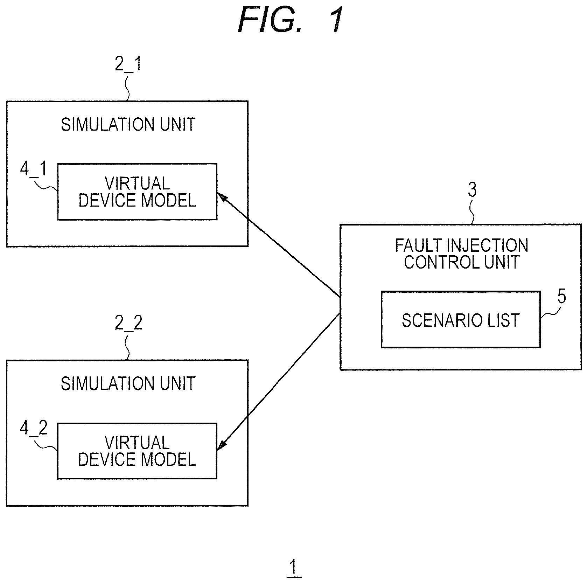

First, before giving a detailed description of the embodiment, a summary of the embodiment will be described. Fig. 1 is a block diagram showing an example of a configuration of a simulation device 1 according to a summary of the embodiment. As shown in Fig. 1, the simulation device 1 includes a simulation unit 2_1, a simulation unit 2_2, and a fault injection control unit 3.

The simulation unit 2_1 (first simulation unit) performs a simulation on a virtual device model 4_1 (first virtual device model) of a first device. In other words, the simulation unit 2_1 performs a simulation using the virtual device model 4_1 obtained by modeling the first device which is a real machine.

The simulation unit 2_2 (second simulation unit) performs a simulation on a virtual device model 4_2 (second virtual device model) of a second device. In other words, the simulation unit 2_2 performs a simulation using the virtual device model 4_2 obtained by modeling the second device which is a real machine. Note that the second device is, for example, a device that performs a process using the first device. For example, the first device can be a microcomputer and the second device can be a plant controlled by the microcomputer.

Here, the simulation environment by the simulation unit 2_1 and the simulation environment by the simulation unit 2_2 are different from each other. For example, the simulation environment by the simulation unit 2_2 is the simulation environment superior to the simulation unit 2_1, and the simulation environment by the simulation unit 2_1 is the simulation environment inferior to the simulation unit 2_2. More specifically, for example, the simulation unit 2_1 is SPILS (Simulated Processor in the Loop) environment, and the simulation unit 2_2 is MILS (Model In the Loop Simulation) environment.

The fault injection control unit 3 injects a fault into each of the virtual device model 4_1 and the virtual device model 4_2 based on a scenario list 5 including a scenario that shows the contents and occurrence conditions of the fault with respect to the first device as well as a scenario that shows the contents and occurrence conditions of the fault with respect to the second device.

As described above, the scenario list 5 describes the contents and occurrence conditions of the faults with respect to the virtual device models 4_1 and 4_2 belonging to the simulation environments different from each other. Then, the fault injection control unit 3 injects faults into the virtual device model 4_1 and the virtual device model 4_2, respectively, according to the scenario list 5. Thus, with the simulation device 1, it is possible to control the occurrence of fault in the virtual device models belonging to the different simulation environments in an integrated manner.

### First Embodiment

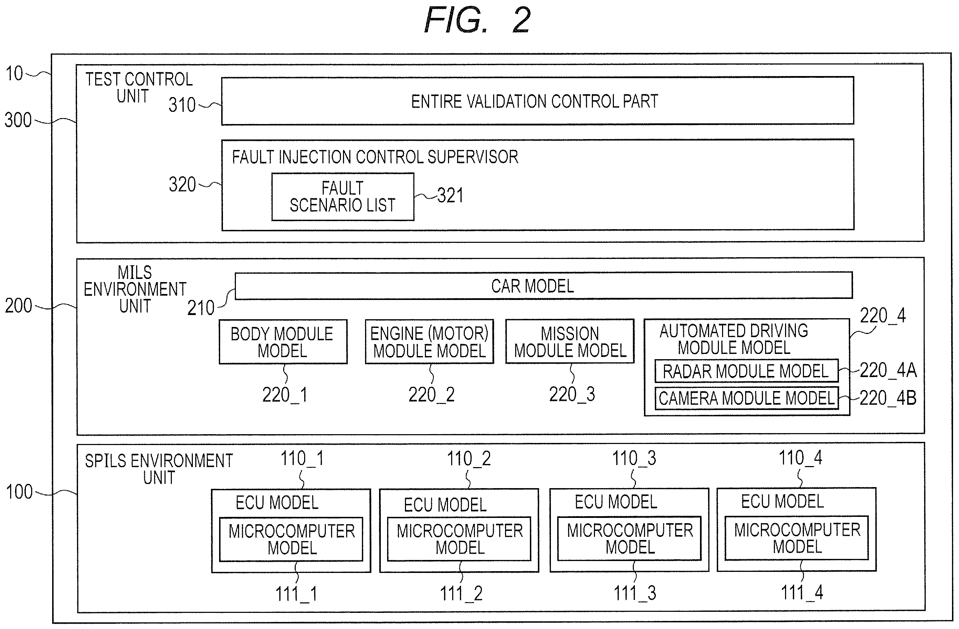

Next, details of the embodiment will be described. Fig. 2 is a block diagram showing an example of a functional configuration of a simulation device 10 according to a first embodiment. The simulation device 10 includes a SPILS environment unit 100, a MILS environment unit 200, and a test control unit 300. Note that the present embodiment describes an example of a model base development environment (virtual development environment) for cars, but objects other than cars can also be used as development targets. In other words, although the present embodiment describes an example of a model of a device used in cars as a virtual device model, the virtual device model can be a model of a device used for a development target other than a car as a virtual device model.

The MILS environment unit 200 is the software that provides the MILS environment and performs a simulation using a virtual device model on a device of the real machine. As described above, the present embodiment describes an example of the development of a car, so that the MILS environment unit 200 performs a simulation on the car and modules to be developed by using a car model 210 and models of the respective configuration modules (for example, a body module model 220_1, an engine (motor) module model 220_2, a mission module model 220_3, as well as an automated driving module 220_4 including a radar module model 220_4A and a camera module model 220_4B). Note that the MILS environment unit 200 corresponds to the simulation unit 2_2 in Fig. 1. Hereinafter, the models of the configuration modules such as the body module model 220_1, the engine (motor) module model 220_2, the mission module model 220_3, and the automated driving module model 220_4 are referred to as a module model 220.

The SPILS environment unit 100 is the software that provides the SPILS environment and performs a simulation using a virtual device model with respect to a device of the real machine. The virtual device model belonging to the SPILS environment unit 100 is the virtual device model of the processor used to control the real machine corresponding to the virtual device model belonging to the MILS environment unit 200. In other words, at least one of the devices to be modeled in the MILS environment unit 200 performs a process using the processor to be modeled in the SPILS environment unit 100. For example, as shown in Fig. 2, the SPILS environment unit 100 simulates the operation of ECU by using ECU models 110_1, 110_2, 110_3, and 110_4, which are virtual device models of the ECU (Electronic Control Unit) which is used to control the configuration modules of the car. Note that the ECU models 110_1, 110_2, 110_3, and 110_4 include microcomputer models 111_1, 111_2, 111_3, and 111_4. The microcomputer models 111_1, 111_2, 111_3, and 111_4 are obtained by modeling the microcomputers mounted on the ECU. Note that the SPILS environment unit 100 corresponds to the simulation unit 2_1 in Fig. 1. Hereinafter, when referring to the ECU models 110_1, 110_2, 110_3, and 110_4 with no particular distinction among them, they are referred to as ECU model 110. Similarly, when referring to the microcomputer models 111_1, 111_2, 111_3, and 111_4 with no particular distinction among them, they are referred to as a microcomputer model 111.

The MILS environment unit 200 performs simulation, for example, with the hour, minute, and second as a time axis. For example, the MILS environment unit 200 manages the time on the millisecond time scale. Further, the SPILS environment unit 100 performs simulation with the clock number of a clock to operate the microcomputer as a time axis.

The test control unit 300 is the software that controls the execution of the test by a simulation using a virtual device model. The test control unit 300 includes an entire validation control part 310 and a fault injection control supervisor 320.

The entire validation control part 310 (test control unit) carries out a test by operating a virtual device model according to a predetermined test scenario. More specifically, when the operation condition defined by the test scenario is satisfied, the entire validation control part 310 controls the car model 210 to perform the operation content defined in the test scenario. The car model 210 performs a process using the module model 220 under the control of the entire validation control part 310. Further, the module model 220 performs, for example, a process using the ECU model 110 and the microcomputer model 111.

Further, the entire validation control part 310 controls the fault injection control supervisor 320. More specifically, the entire validation control part 310 controls whether or not to perform fault injection by the fault injection control supervisor 320. When the entire validation control part 310 controls the fault injection control supervisor 320 to inject a fault, a simulation is performed to simulate operation when a fault occurs in the device. In other words, in this case, it is possible to perform an abnormal system test. Further, when the entire validation control part 310 controls the fault injection control supervisor 320 so as not to inject a fault, a simulation is performed to simulate normal device operation. In other words, in this case, it is possible to perform a normal system test.

The fault injection control supervisor 320 injects faults into the virtual device model used in the simulation of the MILS environment unit 200 and the virtual device model used in the simulation of the SPILS environment unit 100, respectively, based on a fault scenario list 321. Here, the fault scenario list 321 includes a scenario that shows the contents and occurrence conditions of the fault with respect to a device that is modeled by the virtual device model used in the simulation of the MILS environment unit 200, as well as a scenario that shows the contents and occurrence conditions of the fault with respect to a device modeled by the virtual device model used in the simulation of the SPILS environment 100. Note that details of the fault injection by the fault injection control supervisor 320 will be described below.

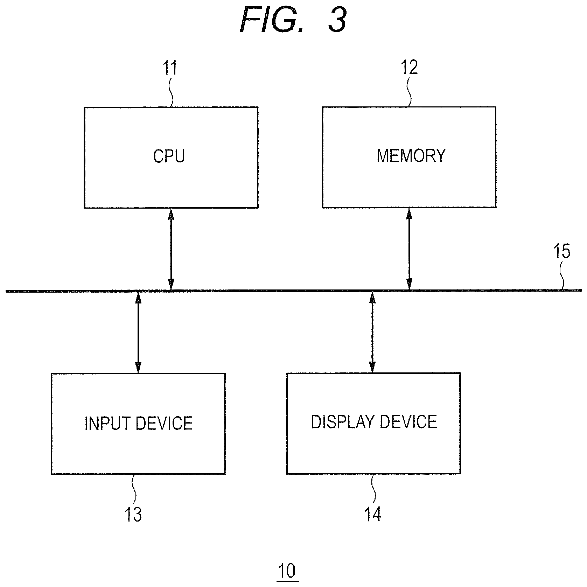

Here, the hardware configuration of the simulation device 10 is described. Fig. 3 is a block diagram showing an example of a hardware configuration of the simulation device 10 according to the first embodiment. The simulation device 10 includes a CPU (Central Processing Unit) 11 as an operational unit (processor), a memory 12 that stores the program and various data, an input device 13 such as a keyboard, a display device 14 such as a flat panel display, and a bus 15 that couples the components to each other.

The memory 12 is configured, for example, with RAM (Random Access Memory) or ROM (Read Only Memory) . The memory 12 stores programs that describe the process of the MILS environment unit 200, the SPILS environment unit 100, and the test control unit 300, as well as software such as different virtual device models. In other words, in the simulation device 10, the CPU 11 executes the programs (software) stored in the memory 12 to perform the processes of the MILS environment unit 200, the SPILS environment unit 100, and the test control unit 300.

The above programs are stored by using various types of non-transitory computer readable media and can be provided to the computer. The non-transitory computer readable media include various types of tangible recording media. Examples of non-transitory computer readable media include magnetic recording media (for example, flexible disk, magnetic tape, hard disk drive), magneto-optical recording media (for example, magneto-optical disk), CD-ROM (Read Only Memory) CD-R, CD-R/W, semiconductor memory (for example, mask ROM, PROM (Programmable ROM), EPRON (Erasable PROM), flash ROM, RAM (Random Access Memory)). The programs can also be provided to the computer by various types of transitory computer readable media. Examples of transitory computer readable media include electric signals, optical signals, and electromagnetic waves. The transitory computer readable medium can provide the programs to the computer through a wired communication path such as an electric wire or an optical fiber, or through a wireless communication path.

The input device 13 is used for operations such as, for example, editing a test scenario list described below and the fault scenario list 321. In this way, the test control unit 300 may set the contents of the test scenario list and the fault scenario list 321 according to the information input from the user through the input device 13. The display device 14 is used, for example, for displaying the test result or the like. In this way, the test control unit 300 may display the test result on the display device 14. Further, the SPILS environment unit 100, the MILS environment unit 200, or the test control unit 300 can also display a user interface such as GUI (Graphical User Interface) or CUI (Character User Interface) on the display device 14.

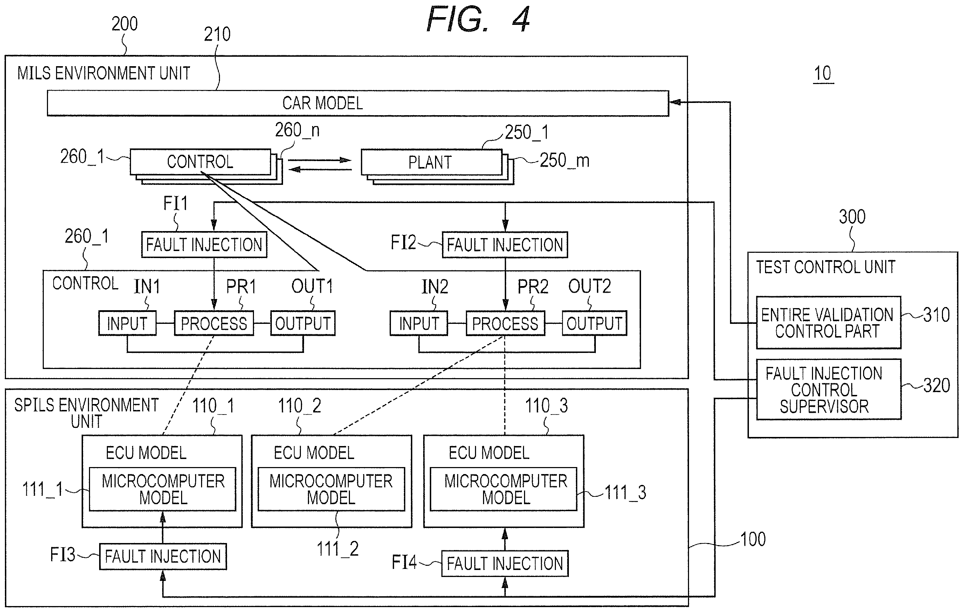

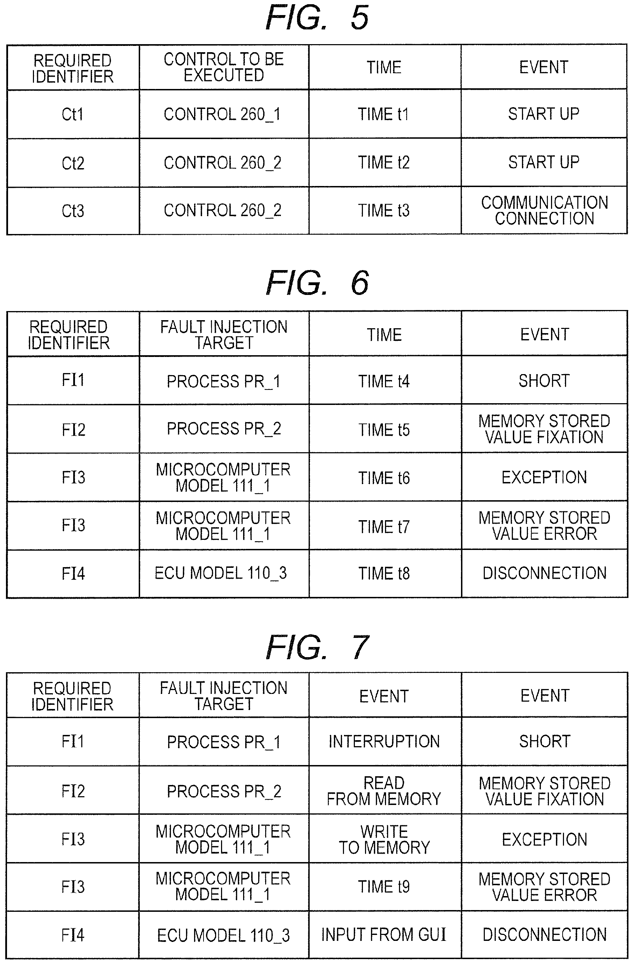

Next, details of fault injection into the virtual device models will be described. Fig. 4 is a schematic diagram showing fault injection in the simulation device 10 according to the first embodiment. Further, Fig. 5 is a table showing an example of a test scenario list that the entire validation control part 310 uses, and Fig. 6 is a table showing an example of a fault scenario list 321 that the fault injection control supervisor 320 uses. Note that the test scenario list and the fault injection scenario list are stored, for example, in the memory 12 in advance.

The MILS environment unit 200 performs controls 260_1 to 260_n on plants 250_1 to 250_m in a simulation with the car model 210. The controls 260_1 to 260_n are simulated by using the module model 220. As an example, Fig. 4 shows focusing on the process in the control 260_1. For example, the control 260_1 is configured with a process (process PR1 in Fig. 4) with the engine (motor) module model 220_2 as well as a process (process PR2 in Fig. 4) with the mission module model 220_3. Note that the example shown in Fig. 4 shows a process in which the processes PR1 and PR2 perform a predetermined process with respect to inputs IN1 and IN2 and then the outputs OUT1 and OUT2 are fed back respectively. However, the present invention is not limited to this example. It goes without saying that simulation of any process can be performed. Further, in the example shown in Fig. 4, as shown in the dashed line, the process PR1 is a process that simulates the process using ECU that is modeled by the ECU model 110_1. Similarly, in the example shown in Fig. 4, the process PR2 is a process that simulates the process using ECU that is modeled by the ECU model 110_2 and using ECU that is modeled by the ECU model 110_3.

The MILS environment unit 200 has fault injection functions FI1 and FI2 for injecting faults into virtual device models. Similarly, the SPILS environment unit 100 has fault injection functions FI3 and FI4 for injecting faults into virtual device models. The fault injection functions FI1, FI2, FI3, and FI4 are, for example, scripts (programs) that reflect fault operations on virtual device models . In the example shown in Fig. 4, the fault injection function FI1 is a function to inject a fault into the process PR1 (namely, the module model 220 that performs the process PR1), and the fault injection function FI2 is a function to inject a fault into the process PR2 (namely, the module model 220 that performs the process PR2) . Further, the fault injection function FI3 is a function to inject a fault into the microcomputer model 111_1, and the fault injection function FI4 is a function to inject a fault into the ECU model 110_3.

The entire validation control part 310 performs a test, for example, according to the test scenario list shown in Fig. 5. For example, "required identifier", "control to be executed", "time", "event", and the like, are described in the test scenario list. In the test scenario list, the "required identifier" is an identifier that identifies each test scenario. The "control to be performed" is information that identifies the control to be executed. The "time" is an example of the information that shows the operation condition of the "event", and shows the occurrence time of the "event". The "event" is information that shows the operation content, which shows the event to be generated when the time managed by the MILS environment unit 200 reaches the "time" of the test scenario.

The entire validation control part 310 monitors the time (time during the test simulation) managed by the MILS environment unit 200. When the time reaches the time described in the test scenario list, the entire validation control part 310 controls the car model 210 to perform the event defined in the test scenario. For example, according to the test scenario list shown in Fig. 5, the entire validation control part 310 monitors the time during the execution of the simulation managed by the MILS environment unit 200, and starts the control 260_1 when the time reaches time t1. In this way, the execution of the processes PR1 and PR2 starts in the MILS environment and then the ECU models 110_1 to 110_3 are executed in the SPILS environment as required.

Further, for example, when the execution of a test with occurrence of fault is instructed from the user through the user interface (namely, when the execution of abnormal system validation is instructed), the entire validation control part 310 instructs the fault injection control supervisor 320 to control the occurrence of fault.

The fault injection control supervisor 320 performs fault injection, for example, according to the fault scenario list shown in Fig. 6. For example, "required identifier", "fault injection target", "time", "event", and the like, are described in the test scenario list. In the fault scenario list, the "required identifier" is an identifier that identifies each fault scenario. In the example shown in Fig. 6, the information that identifies fault injection functions (fault injection functions FI1, FI2, FI3, FI4) used for fault injection is described as identifiers. The "fault injection target" is information that identifies the object into which a fault is injection. The "time" is information that shows the fault occurrence condition, and shows the occurrence time of the fault shown in the "event". The "event" is information that shows the fault content, showing the event to be generated when the time that the MILS environment unit 200 manages reaches the "time" of the fault scenario list.

The fault injection control supervisor 320 monitors the time that the MILS environment 200 manages. When the time reaches the time described in the fault scenario list, the fault injection control supervisor 320 instructs the fault injection function that executes the event defined in the fault scenario to perform fault injection. For example, according to the fault scenario list shown in Fig. 6, the fault injection control supervisor 320 monitors the time during the execution of the simulation that the MILS environment 200 manages, and when the time reaches time t4, the fault injection control supervisor 320 instructs the fault injection function FI1 to cause a short circuit to occur in the process PR1 (the virtual device model that performs the process PR1). Further, when the time of the MILS environment 200 reaches time t5, the fault injection control supervisor 320 instructs the fault injection function FI2 to cause a memory store value fixation to occur in the process PR2 (the virtual device model that performs the process PR2) . Further, when the time of the MILS environment unit 200 reaches time t6, the fault injection control supervisor 320 instructs the fault injection function FI3 to cause an exception process to occur in the microcomputer model 111_1. Further, when the time of the MILS environment unit 200 reaches time t7, the fault injection control supervisor 320 instructs the fault injection function FI3 to cause a memory stored value error to occur in the microcomputer model 111_1. Further, when the time of the MILS environment unit 200 reaches time t8, the fault injection control supervisor 320 instructs the fault injection function FI4 to cause a circuit disconnection to occur in the ECU model 110_3.

The foregoing has described the first embodiment. In the simulation device 10 according to the first embodiment, the fault injection control supervisor 320 injects faults into the virtual device model of the MILS environment as well as the virtual device model of the SPILS environment, according to the information defined in the fault scenario list. Thus, it is possible to control the models belonging to different simulation environments in an integrated manner. Further, in particular in the present embodiment, the fault scenario list includes the fault occurrence timing ("time" in Fig. 6) at the time that the MILS environment unit 200 manages, and when the time that the MILS environment unit 200 manages reaches this occurrence timing, the fault injection control supervisor 320 instructs the SPILS environment unit 100 or the MILS environment unit 200 to cause the fault of the fault content associated with this occurrence timing to occur. Thus, in synchronous simulation with the MILS environment and the SPILS environment, it is possible to simulate the behavior of the device when a fault occurs. Thus, for example, even if the whole car is modeled by using different simulation environments as described above, a plurality of virtual device models can be treated as a common simulation model, so that it is possible to easily perform the design and validation of the configurations as a whole. Further, for example, it is also possible to easily perform validation to ensure safety in accordance with the functional safety process.

Further, the fault scenario list 321 may include a scenario that shows the contents and occurrence conditions of the fault with respect to the circuit inside the microcomputer. In this case, with the simulation device 10 according to the present embodiment, it is possible to simulate the fault on the circuit inside the microcomputer in simulation.

### Second Embodiment

Next, a second embodiment will be described. In the first embodiment, the fault injection control supervisor 320 uses the time as a fault occurrence condition. However, the fault occurrence condition can also be factors other than time. The second embodiment is different from the first embodiment in that a predetermined event is used as a fault occurrence condition.

Fig. 7 is a table showing an example of the fault scenario list 321 that the fault injection control supervisor 320 uses in the second embodiment. As shown in Fig. 7, in the present embodiment, the fault scenario list defines trigger events as fault occurrence conditions. In other words, the fault injection control supervisor 320, which controls the fault occurrence on a time-driven basis in the first embodiment, controls the fault occurrence on an event-driven basis in the second embodiment.

Note that, similarly to the first embodiment, time can be defined as a trigger event. It is also possible that the trigger event is an occurrence of an instruction from a user interface such as GUI, namely, an occurrence of an instruction from the user.

The fault injection control supervisor 320 monitors, for example, the process state of the virtual device models in the MILS environment unit 200 and the SPILS environment unit 100, the time of ongoing simulation that the MILS environment unit 200 manages, and the user interface, to check whether or not an event defined in the fault scenario list occurred. Then, when an event defined in the fault scenario list occurred, the fault injection control supervisor 320 instructs the SPILS environment unit 100 or the MILS environment unit 200 to cause the event associated with the particular event in the fault scenario list to occur.

For example, according to the fault scenario list shown in Fig. 7, when a predetermined interruption process occurs, the fault injection control supervisor 320 instructs the fault injection function FI1 to cause a short circuit to occur in the process PR1 (more specifically, the virtual device model that performs the process PR1). Further, when a predetermined read process from the memory occurs, the fault injection control supervisor 320 instructs the fault injection function FI2 to cause a memory stored value fixation to occur in the process PR2 (the virtual device model that performs the process PR2) . Further, when a predetermined write process to the memory occurs, the fault injection control supervisor 320 instructs the fault injection function FI3 to cause an exception process to occur in the microcomputer model 111 1. Further, when the time of the MILS environment unit 200 reaches time t9, the fault injection control supervisor 320 instructs the fault injection function FI3 to cause a memory stored value error to occur in the microcomputer model 111_1. Further, when an instruction is input through the GUI, the fault injection control supervisor 320 instructs the fault injection function FI4 to cause a circuit disconnection to occur in the ECU model 110_3.

As described above, in the second embodiment, the fault scenario list includes a predetermined event that occurs in simulation with the SPILS environment unit 100 or the MILS environment unit 200. Then, when the predetermined event occurs, the fault injection control supervisor 320 instructs the SPILS environment unit 100 or the MILS environment unit 200 to cause a fault of the fault content associated with this event to occur. Thus, it is possible to simulate the occurrence of faults in various modes in synchronous simulation with the MILS environment unit and the SPILS environment.

Note that the fault occurrence condition in a virtual device model of the MILS environment unit 200 can be an event in the particular virtual device model, or an event in another virtual device model (another virtual device model of the MILS environment unit 200 or a virtual device model of the SPILS environment unit 100). Similarly, the fault occurrence condition in a virtual device model of the SPILS environment unit 100 can be an event in the particular virtual device model, or an event of another virtual device model (another virtual device model of the SPILS environment unit 100 or a virtual device model of the MILS environment unit 200).

Thus, when a predetermined event occurs in the simulation with the SPLS environment unit 100, the fault injection control supervisor 320 instructs the MILS environment unit 200 to cause a fault of the fault content associated with the event to occur. Similarly, for example, when a predetermined event occurs in the simulation with the MILS environment unit 200, the fault injection control supervisor 320 instructs the SPILS environment unit 100 to cause a fault of the fault content associated with the event to occur. In this way, in the present embodiment, it is possible to inject a fault into a virtual device model with the event that occurred in a different simulation environment as a trigger.

Further, as described above, the fault occurrence condition defined in the fault scenario list can also be an instruction from the user interface. In other words, the fault injection control supervisor 320 may instruct the SPILS environment unit 100 or the MILS environment unit 200 to cause a fault of a predetermined fault content to occur, according to the instruction from the user interface. With this configuration, the user can cause a fault to occur at an arbitrary timing during the simulation.

### Third Embodiment

The first and second embodiments have shown an example in which the test control unit 300 is configured as software different from the MILS environment unit 200 and the SPILS environment unit 100. However, the test control unit 300 can be integrated into the simulation environment. In the present embodiment, the test control unit 300 is included in the MILS environment unit 200. In other words, the entire validation control part 310 and the fault injection control supervisor 320 are included as a function of the MILS environment unit 200.

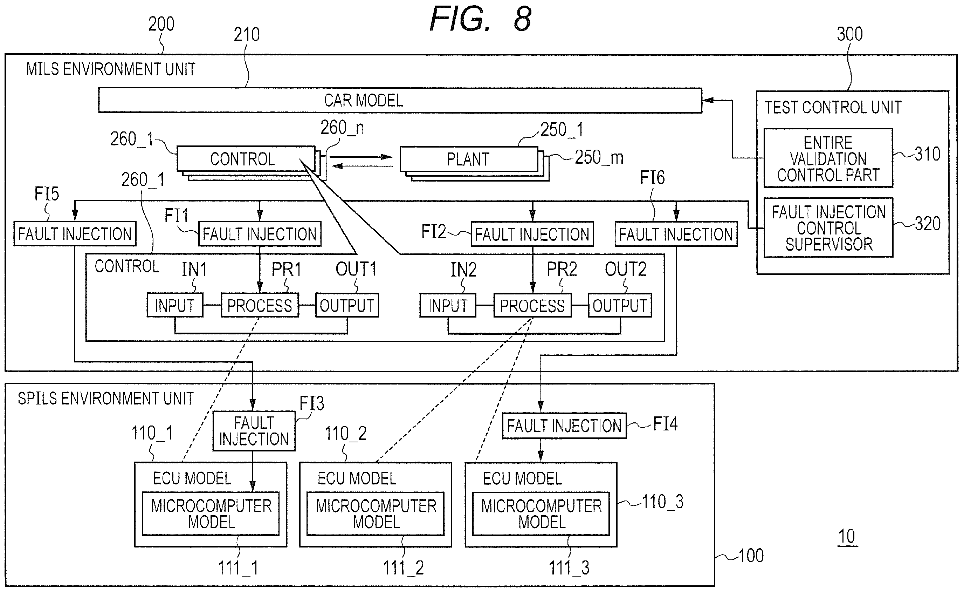

Fig 8 is a schematic diagram showing fault injection in the simulation device 10 according to a third embodiment. As described above, in the simulation device 10 according to the third embodiment, the test control unit 300 is present as a block in the MILS environment. Further, along with this, the test control unit 300 controls the injection of faults into the virtual device models in the SPILS environment unit 100 through fault injection functions FI5 and FI6 which are other blocks in the MILS environment. Note that, similarly to the embodiments described above, the fault injection into the virtual device models in the MILS environment unit 200 is performed by using the fault injection functions FI1 and FI2.

The fault injection functions FI5 and FI6 are scripts (programs) having a function that intermediates injection of faults into the virtual device models of the SPILS environment unit 100. In other words, the fault injection functions FI5 and FI6 are interfaces for fault injection. When receiving an instruction of fault injection from the fault injection control supervisor 320, the fault injection functions FI5 and FI6 instruct the fault injection functions FI3 and FI4 of the SPILS environment unit 100 to inject faults.

According to the present embodiment, it is possible to perform fault injection by the fault injection control supervisor 320 as one function of the simulation software. Note that the present embodiment has shown an example in which the MILS environment unit 200 includes both the entire validation control part 310 and the fault injection control supervisor 320. However, it may also be possible that only either one of the entire validation control part 310 and the fault injection control supervisor 320 is included in the MILS environment unit 200 or that the SPILS environment unit 100 includes one or both of them.

While the invention made by the present inventors has been concretely described based on exemplary embodiments, the present invention is not limited to the specific exemplary embodiments. It is needless to say that various modifications may be made without departing from the scope of the present invention.

## Claims

1. A simulation device comprising:
a first simulation unit that performs a simulation on a first virtual device model of a first device;
a second simulation unit that performs a simulation on a second virtual device model of a second device that performs a process using the first device; and
a fault injection control unit that injects faults into the first virtual device model and the second virtual device model, respectively, based on a scenario list including a scenario that shows the contents and occurrence conditions of the fault with respect to the first device as well as a scenario that shows the contents and occurrence conditions of the fault with respect to the second device.

2. The simulation device according to claim 1,
wherein the scenario list includes the fault occurrence timing at the time that the second simulation unit manages as a fault occurrence condition, and
wherein, when the time that the second simulation unit manages reaches the occurrence timing, the fault injection control unit instructs the first simulation unit or the second simulation unit to cause a fault of the fault content associated with the occurrence timing to occur.

3. The simulation device according to claim 1,
wherein the scenario list includes a predetermined event that occurs in simulation by the first simulation unit or the second simulation unit, as a fault occurrence condition, and
wherein, when the predetermined event occurs, the fault injection control unit instructs the first simulation unit or the second simulation unit to cause a fault of the fault content associated with the event to occur.

4. The simulation device according to claim 3,
wherein, when the predetermined event occurs in simulation by the first simulation unit, the fault injection control unit instructs the second simulation unit to cause a fault of the fault content associated with the event to occur.

5. The simulation device according to claim 1,
wherein the fault injection control unit instructs the first simulation unit or the second simulation unit to cause a fault of a predetermined fault content to occur according to an instruction from a user interface.

6. The simulation device according to claim 1,
wherein the second simulation unit is the simulation environment superior to the first simulation unit, and the first simulation unit is the simulation environment inferior to the second simulation unit.

7. The simulation device according to claim 6,
wherein the first simulation unit is SPILS (Simulated Processor In the Loop) environment, and the second simulation unit is MILS (Model In the Loop Simulation) environment.

8. The simulation device according to claim 1,
wherein the first device is a microcomputer, and wherein the scenario list includes a scenario that shows the contents and occurrence conditions of fault with respect to the circuit inside the microcomputer.

9. The simulation device according to claim 1,
wherein the fault injection control unit is included as a function of the second simulation unit.

10. A computer readable storage medium that allows a computer to perform the steps including:
a first simulation step for performing a simulation on a first virtual device model of a first device;
a second simulation step for performing a simulation on a second virtual device model of a second device that performs a process by using the first device; and
a fault injection control step for injecting faults into the first virtual device model and the second virtual device model, respectively, based on a scenario list including a scenario that shows the contents and occurrence conditions of the fault with respect to the first device as well as a scenario that shows the contents and occurrence conditions of the fault with respect to the second device.
